# EUROPEAN PATENT APPLICATION

(11) **EP 2 085 816 A1**
(43) Date of publication of application: **05.08.2009**
(21) Application number: 09000967.1
(22) Date of filing: 23.01.2009
(51) Int. Cl.: G02F 1/1345, H01L 23/532, H01L 27/32

(54) **Electrode substrate having conductive layers with different properties made of conductive materials with different properties formed on transparent base material**

(30) Priority: 29.01.2008 JP 2008017889
(71) Applicant: FCM Co., Ltd., Osaka-shi, Osaka 537-0003 (JP)
(72) Inventor: Miura, Shigeki, Osaka-shi Osaka 537-0003 (JP)
(74) Representative: Grünecker, Kinkeldey, Stockmair & Schwanhäusser Anwaltssozietät

(57) **Abstract**

An electrode substrate (100) of the present invention includes a first conductive layer (102) made of a first conductive material and a second conductive layer (103) made of a second conductive material formed on a transparent base material (101), wherein the first conductive layer (102) is formed on the transparent base material (101), the second conductive layer (103) is formed on the transparent base material (101) to cover the first conductive layer (102), both the first conductive layer (102) and the second conductive layer (103) form a fine wiring pattern, the second conductive layer (103) has a width (W₂) not less than 1.5 times and not more than 300 times that (W₁) of the first conductive layer (102), and the second conductive material has a light transmissivity higher than that of the first conductive material, and a conductivity lower than that of the first conductive material.

## Description

This nonprovisional application is based on Japanese Patent Application No. 2008-017889 filed on January 29, 2008 with the Japan Patent Office, the entire contents of which are hereby incorporated by reference.

### BACKGROUND OF THE INVENTION

### Field of the Invention

The present invention relates to an electrode substrate having conductive layers formed on a transparent base material, and achieving both transparency and conductivity.

### Description of the Background Art

Electrode substrates used for example in a liquid crystal display device, an organic EL (organic electroluminescence), electronic paper, and the like are required to have both transparency and conductivity. This is because, if transparency is insufficient, a display screen is darkened, and if conductivity is insufficient, it becomes difficult to increase the area of the display screen and a response speed is reduced.

Conventionally, an ITO (In/Sn oxide) and a Zn-based oxide have been used for transparent electrodes used in such electrode substrates, and these transparent electrodes have been required to achieve both transparency and conductivity, although these properties are conflicting such that an increase in thickness is required to improve conductivity, whereas the increase in thickness results in a reduction in transparency. Further, since these transparent electrodes are made of expensive metal oxides, it has also been required to improve conductivity with a thin thickness for the purpose of cost reduction. Furthermore, since these transparent electrodes are made of oxides and thus likely to have cracks and the like, it has also been required to improve strength thereof to prevent resultant poor conductivity. In addition, while these oxides tend to exhibit reduced conductivity if crystallization is insufficient, sufficient crystallization cannot be achieved when a base material forming the electrodes is made of resin or the like, because conditions for forming the oxides are limited. Therefore, the reduced conductivity has been particularly acknowledged as a problem.

Although various attempts have been proposed (Japanese Patent Laying-Open Nos. 2000-072526, 2000-072537, 2003-078153, and 2004-355972) for the purpose of solving these points, further improvement has been required to enhance the performance.

### SUMMARY OF THE INVENTION

The present invention has been made in view of the current situation as described above, and one object of the present invention is to provide an electrode substrate highly achieving both transparency and conductivity.

The present invention has been made based on a totally new approach of forming two types of conductive layers, one ensuring transparency and the other ensuring conductivity, instead of achieving both transparency and conductivity with only one conductive layer as in conventional techniques.

Specifically, an electrode substrate of the present invention includes a first conductive layer made of a first conductive material and a second conductive layer made of a second conductive material formed on a transparent base material, wherein the first conductive layer is formed on the transparent base material, the second conductive layer is formed on the transparent base material to cover the first conductive layer, both the first conductive layer and the second conductive layer form a fine wiring pattern, the second conductive layer has a width not less than 1.5 times and not more than 300 times that of the first conductive layer, and the second conductive material has a light transmissivity higher than that of the first conductive material, and a conductivity lower than that of the first conductive material.

Preferably, the first conductive material is at least one type of metal selected from the group consisting of Ni, Cu, Ag, Al, and Cr, or an alloy containing the metal, and the second conductive material is an oxide of at least one type of metal selected from the group consisting of Ru, Re, Pb, Cr, Sn, In, and Zn.

Preferably, the first conductive layer has a thickness of not less than 0.001 µm and not more than 5 µm, and a width of not less than 1 µm and not more than 3 mm, and the second conductive layer has a thickness of not less than 0.001 µm and not more than 1 µm, and a width of not less than 1.5 µm.

The present invention is also directed to a part or a product including the electrode substrate described above.

With the structure as described above, the electrode substrate of the present invention succeeds in highly achieving both transparency and conductivity.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic cross sectional view of an electrode substrate of the present invention.
Fig. 2 is a schematic cross sectional view of a work-in-process item in the course of manufacturing the electrode substrate, in a state where a dry film is laminated on a transparent base material, and exposed and developed.
Fig. 3 is a schematic cross sectional view of the work-in-process item in the course of manufacturing the electrode substrate, in a state where a first conductive layer is formed over the dry film.
Fig. 4 is a schematic cross sectional view of the work-in-process item in the course of manufacturing the electrode substrate, in a state where the first conductive layer in the form of a wiring pattern is formed on the transparent base material.
Fig. 5 is a schematic cross sectional view of the work-in-process item in the course of manufacturing the electrode substrate, in a state where a dry film for forming a second conductive layer is laminated on the transparent base material, and exposed and developed.
Fig. 6 is a schematic cross sectional view of the work-in-process item in the course of manufacturing the electrode substrate, in a state where the second conductive layer is formed over the first conductive layer.
Fig. 7 is a schematic cross sectional view of a work-in-process item in the course of manufacturing the electrode substrate, in a state where a first conductive layer is formed all over one side of a transparent base material.
Fig. 8 is a schematic cross sectional view of the work-in-process item in the course of manufacturing the electrode substrate, in a state where a dry film is laminated on the first conductive layer, and exposed and developed.
Fig. 9 is a schematic cross sectional view of the work-in-process item in the course of manufacturing the electrode substrate, in a state where the first conductive layer in the form of a wiring pattern is formed on the transparent base material.
Fig. 10 is a schematic cross sectional view of the work-in-process item in the course of manufacturing the electrode substrate, in a state where a second conductive layer is formed over the first conductive layer.
Fig. 11 is a schematic cross sectional view of the work-in-process item in the course of manufacturing the electrode substrate, in a state where a dry film is laminated on the second conductive layer, and exposed and developed.
Fig. 12 is a schematic cross sectional view of an electrode substrate of a comparative example.

### DESCRIPTION OF THE PREFERRED EMBODIMENTS

Hereinafter, the present invention will be described in more detail. In the description of the embodiments below, the present invention will be described with reference to the drawings, in which identical or corresponding parts will be designated by the same reference numerals in the present application.

### <Electrode Substrate>

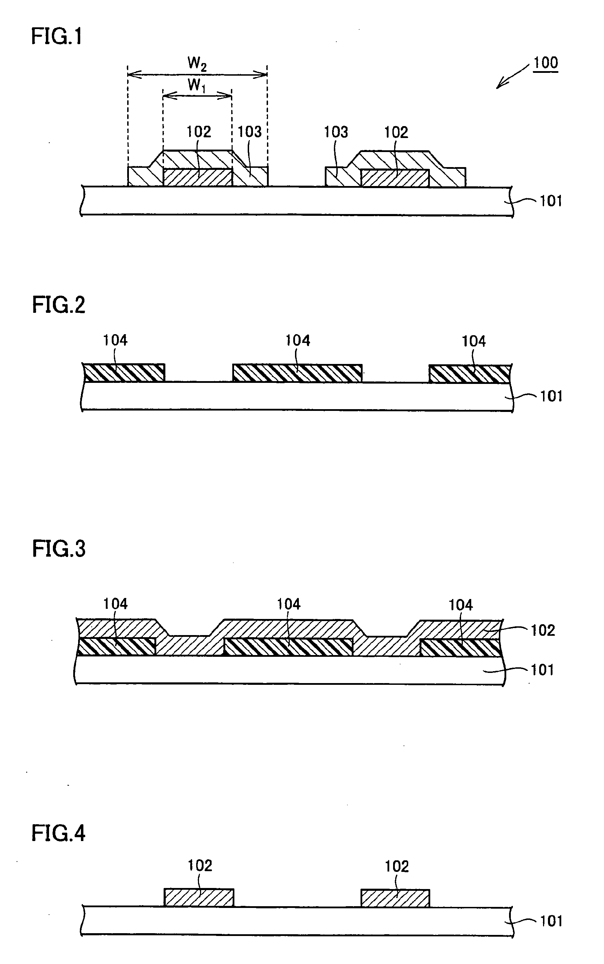

An electrode substrate 100 of the present invention, as shown in Fig. 1 showing a schematic cross sectional view thereof, includes a first conductive layer 102 made of a first conductive material and a second conductive layer 103 made of a second conductive material formed on a transparent base material 101. The first conductive layer 102 is formed on transparent base material 101, and the second conductive layer 103 is formed on transparent base material 101 to cover at least a portion of the first conductive layer 102.

Specifically, electrode substrate 100 of the present invention is characterized by forming two different conductive layers, that is, the first conductive layer 102 and the second conductive layer 103, on transparent base material 101, causing the first conductive layer 102 to mainly ensure conductivity and causing the second conductive layer 103 to mainly ensure transparency. With this structure, both transparency and conductivity can be highly achieved. Generally in the present invention, a conductive layer formed of the first conductive layer and the second conductive layer as described above often forms a fine wiring pattern (or wiring circuit) on the transparent base material.

It is to be noted that the electrode substrate of the present invention as described above is included within the scope of the present invention even if it includes the aforementioned structure only in a portion of the electrode substrate, and that, even if there is a case where another conductive layer other than the first conductive layer and the second conductive layer or another circuit component is formed, such a case is not considered as departing from the scope of the present invention.

### <Transparent Base Material>

The transparent base material used in the present invention is not particularly limited as long as it has transparency and insulation property, and any conventionally known insulating transparent base material used for this type of application can be used without particular limitation. Preferably, the transparent base material in the present invention has a light transmissivity of not less than 50% at a wavelength of 350 to 800 nm, and more preferably, a light transmissivity of not less than 80%. This is because, if the light transmissivity is less than 50%, the transparent base material may not serve as a transparent electrode.

As a material for such a transparent base material, it is preferable to select at least one type selected from the group consisting of polymers such as polyethylene terephthalate (PET), polyethylene naphthalate (PEN), polycarbonate (PC), acrylic resin, aramid, a liquid crystal polymer, polyimide, and the like, glass, and the aforementioned polymers and glass having a surface coated with a transparent and insulating organic or inorganic compound. In particular, PET is inexpensive and excellent in strength without having cracks and the like, and thus PET can be used particularly suitably.

Preferably, the transparent base material has a thickness of not less than 3 µm and not more than 5 mm. If the thickness is less than 3 µm, the transparent base material may not have sufficient strength or may be difficult to be processed, and if the thickness is more than 5 mm, the light transmissivity may be worsened. The upper limit of the thickness is more preferably 3 mm, further preferably 1 mm, and the lower limit of the thickness is more preferably 30 µm, further preferably 50 µm.

### <First Conductive Layer>

The first conductive layer of the present invention has a function of mainly ensuring the conductivity of the electrode substrate, and is made of the first conductive material and formed on the transparent base material described above. Generally, such a first conductive layer is formed to construct a fine wiring pattern.

As the first conductive material, any conductive material can be used without particular limitation as long as it has good conductivity, and it is particularly preferable to use at least one type of metal selected from the group consisting ofNi, Cu, Ag, Al, and Cr, or an alloy containing the metal. This is because these metals or the alloys thereof are inexpensive and excellent in conductivity, and have excellent strength without having cracks and the like (i.e., have stable quality). In particular, Cu is inexpensive and has low electrical resistance (i.e., has good conductivity), exhibits excellent ductility, and has no cracks, and thus Cu can be used particularly suitably.

Preferably, the first conductive layer made of such a first conductive material has a thickness of not less than 0.001 µm and not more than 5 µm, and a width of not less than 1 µm and not more than 3 mm, depending on the kind of the first conductive material. If the thickness is less than 0.001 µm, pin holes are likely to be generated, and thereby electrical resistance may be increased, and if the thickness is more than 5 µm, it is difficult to narrow the width, and as a result, transparency is worsened. On the other hand, if the width is less than 1 µm, conductivity may be reduced, and if the width is more than 3 mm, transparency may be worsened. In this manner, although the first conductive layer itself does not have transparency, it intends to prevent light shielding property (i.e., a reduction in light transmissivity) while maintaining high conductivity, by reducing its thickness and width (i.e., by being formed as fine wiring).

The upper limit of the thickness of such a first conductive layer is more preferably 0.5 µm, further preferably 0.3 µm, and the lower limit thereof is more preferably 0.01 µm, further preferably 0.1 µm. Further, the upper limit of the width of the first conductive layer is more preferably 50 µm, further preferably 15 µm, and the lower limit thereof is more preferably 3 µm, further preferably 5 µm.

The first conductive layer of the present invention may also be formed as a plurality of layers made of first conductive materials different from each other. For example, the first conductive layer can be formed by firstly forming a layer made of an alloy ofNi and Cr (referred to as a "first conductive layer a" for convenience sake) on a transparent base material and then forming a layer made of Cu (referred to as a "first conductive layer b" for convenience sake) thereon. In this case, the first conductive layer a and the first conductive layer b have the same width, and the sum of the thickness of the first conductive layer a and the thickness of the first conductive layer b is equal to the thickness of the first conductive layer.

Since the first conductive layer is made of the first conductive material that is essentially a metal as described above, the first conductive layer has an disadvantage that migration (i.e., a phenomenon where a metal used as wiring or an electrode migrates on an insulator and causes poor insulation or short circuit) is likely to occur. However, the occurrence of migration can be prevented by forming the second conductive layer described later (in particular, by forming the second conductive layer to cover the first conductive layer). In this manner, with the structure of the present invention, the present invention produces an effect that the occurrence of migration in the first conductive layer can be prevented significantly effectively.

### <Second Conductive Layer>

The second conductive layer of the present invention has a function of mainly ensuring transparency while having conductivity, and is made of the second conductive material and formed on the transparent base material to cover at least a portion of the first conductive layer described above. Preferably, such a second conductive layer is formed to cover all over the first conductive layer formed as fine wiring as described above. However, even if there is a case where the first conductive layer is partly exposed on a surface, such a case is not considered as departing from the scope of the present invention.

The second conductive material is not particularly limited as long as it has conductivity and transparency, and it is particularly preferable to use an oxide of at least one type of metal selected from the group consisting of Ru, Re, Pb, Cr, Sn, In, and Zn, because such an oxide has excellent transparency as well as having conductivity. More preferable examples of the second conductive material include ITO (an oxide of Sn and In with a mass ratio of Sn : In : O = 2 to 15 : 65 to 95 : 3 to 30), SnO (an oxide of Sn), RuO (an oxide ofRu), ReO (an oxide of Re), ZnO (an oxide of Zn), and the like.

Preferably, the second conductive layer made of such a second conductive material has a thickness of not less than 0.001 µm and not more than 1 µm, and a width of not less than 1.5 µm. If the thickness is less than 0.001 µm, pin holes are likely to be generated, and thereby electrical resistance may be increased, and if the thickness is more than 1 µm, transparency is worsened. On the other hand, if the width is less than 1.5 µm, the ratio of the first conductive layer is relatively increased, and transparency is worsened. The upper limit of the width is not particularly limited, and can be set arbitrarily within a range in which the width has a ratio described later to the width of the first conductive layer. In this manner, although the second conductive layer has a conductivity lower than that of the first conductive layer, it intends to improve transparency. Further, the occurrence of migration in the first conductive layer can be prevented by forming the second conductive layer to cover the first conductive layer.

The upper limit of the thickness of such a second conductive layer is more preferably 0.1 µm, further preferably 0.05 µm, and the lower limit thereof is more preferably 0.01 µm, further preferably 0.03 µm. Further, the upper limit of the width of the second conductive layer is more preferably 600 µm, further preferably 300 µm, and the lower limit thereof is more preferably 4.5 µm, further preferably 7.5 µm.

### <Properties of the First Conductive Layer and the Second Conductive Layer>

The second conductive layer of the present invention as described above is required to have a width not less than 1.5 times and not more than 300 times that of the first conductive layer. Thereby, conductivity and transparency sufficient for the entire electrode substrate can both be achieved. If the second conductive layer has a width less than 1.5 times that of the first conductive layer, the ratio of the first conductive layer is increased to obtain a predetermined conductivity, and thus sufficient transparency cannot be obtained. If the second conductive layer has a width more than 300 times that of the first conductive layer, the ratio of the second conductive layer is increased, and thus it is difficult to obtain sufficient conductivity. The upper limit of the width of the second conductive layer is more preferably 100 times, further preferably 50 times that of the first conductive layer, and the lower limit thereof is more preferably 10 times, further preferably 20 times that of the first conductive layer.

It is to be noted that the width of the first conductive layer refers to a length in a direction vertical (i.e., lateral) to a length direction of the first conductive layer formed as fine wiring, which is shown for example in Fig. 1 as a length represented by W₁. Similarly, the width of the second conductive layer refers to a length represented by W₂ in Fig. 1. In this manner, the respective widths are defined to compare the widths of these two conductive layers at an identical point where the conductive layers are stacked.

Ideally, the ratio between the widths of the first conductive layer and the second conductive layer defined as described above should be satisfied in all the area in the length direction. However, even if there is a case where a portion not satisfying the above ratio is included in not more than 20% of the area in the length direction, such a case is not considered as departing from the scope of the present invention.

Further, in the first conductive material constituting the first conductive layer and the second conductive material constituting the second conductive layer, the second conductive material has a light transmissivity higher than that of the first conductive material, and a conductivity lower than that of the first conductive material. Thereby, conductivity can be ensured by the first conductive layer, and transparency can be ensured by the second conductive layer. Although the term "conductivity" used in the present invention refers to electrical conductivity, an electrical resistance value may be used as a measure.

It is to be noted, although the light transmissivity and the conductivity of the first conductive material and the second conductive material to be compared are measured under an identical measurement condition, the measurement condition may be any of conventionally known measurement conditions.

### <Manufacturing Method>

The method of manufacturing the electrode substrate of the present invention is not particularly limited as long as the electrode substrate has a structure as described above. Although the electrode substrate can be manufactured, for example, by any of manufacturing methods A to D as described below, the manufacturing methods are not limited thereto.

### <Manufacturing Method A>

A resist is applied on the transparent base material such that the first conductive layer will form a desired fine wiring pattern (hereinafter also simply referred to as "fine wiring"), and the resist is exposed and developed. Then, the first conductive material is sputtered in the form of the desired fine wiring, and thereby the first conductive layer is formed. Thereafter, the resist is removed.

Subsequently, a resist is applied in a pattern such that the second conductive layer will be formed to cover the first conductive layer formed as fine wiring as described above, and the resist is exposed and developed. Then, the second conductive material is sputtered in the pattern, and thereby the second conductive layer is formed. Thereafter, the resist is removed. With this manner, the electrode substrate including the first conductive layer and the second conductive layer formed on the transparent base material can be manufactured.

### <Manufacturing Method B>

The first conductive material is sputtered onto the entire surface of the transparent base material, and thereby the first conductive layer is formed. Then, a resist is applied on the first conductive layer in a pattern such that the first conductive layer will be formed as desired fine wiring, and the resist is exposed and developed. Thereafter, etching is performed to remove an unnecessary portion of the first conductive layer. Then, the resist is removed, and thereby the first conductive layer is formed as fine wiring.

Subsequently, the second conductive material is sputtered onto the entire surface of the transparent base material having the first conductive layer formed thereon as described above, and thereby the second conductive layer is formed. Then, a resist is applied on the second conductive layer in a pattern such that the second conductive layer will cover the first conductive layer, and the resist is exposed and developed. Thereafter, etching is performed to remove an unnecessary portion of the second conductive layer. Then, the resist is removed, and thereby the second conductive layer is formed to cover the first conductive layer. With this manner, the electrode substrate including the first conductive layer and the second conductive layer formed on the transparent base material can be manufactured.

### <Manufacturing Method C>

A resist is applied on the transparent base material in a pattern such that the first conductive layer will be formed as desired fine wiring, and the resist is exposed and developed. Then, the first conductive material is sputtered in the form of the desired fine wiring, and thereby the first conductive layer is formed. Thereafter, the resist is removed.

Subsequently, the second conductive material is sputtered onto the entire surface of the transparent base material having the first conductive layer formed thereon as described above, and thereby the second conductive layer is formed. Then, a resist is applied on the second conductive layer in a pattern such that the second conductive layer will cover the first conductive layer, and the resist is exposed and developed. Thereafter, etching is performed to remove an unnecessary portion of the second conductive layer. Then, the resist is removed, and thereby the second conductive layer is formed to cover the first conductive layer. With this manner, the electrode substrate including the first conductive layer and the second conductive layer formed on the transparent base material can be manufactured.

### <Manufacturing Method D>

Using the transparent base material having the first conductive layer formed on the entire surface thereof, a resist is applied on the first conductive layer in a pattern such that the first conductive layer will be formed as desired fine wiring, and the resist is exposed and developed. Thereafter, etching is performed to remove an unnecessary portion of the first conductive layer. Then, the resist is removed, and thereby the first conductive layer is formed as fine wiring.

Subsequently, a resist is applied in a pattern such that the second conductive layer will be formed to cover the first conductive layer formed as fine wiring as described above, and the resist is exposed and developed. Then, the second conductive material is sputtered in the pattern, and thereby the second conductive layer is formed. Thereafter, the resist is removed. With this manner, the electrode substrate including the first conductive layer and the second conductive layer formed on the transparent base material can be manufactured.

A dry film can be used as the resist in manufacturing methods A to D described above. Further, various types of pretreatment such as cleaning and cation bombardment can also be performed onto the transparent base material before the first conductive layer is formed thereon, and/or onto the first conductive layer before the second conductive layer is formed thereon.

Although the first conductive layer and the second conductive layer are formed by sputtering in manufacturing methods A to D described above, the method of forming the same is not limited thereto, and any of conventionally known methods such as deposition, electroplating, electroless plating, printing, and the like can also be employed. The method of forming the wiring pattern of the first conductive layer and the second conductive layer is also not particularly limited, and may be a method directly forming a pattern or may be a method forming a pattern by etching.

### <Application>

The electrode substrate of the present invention can be used significantly effectively as an electrode for an electronic product/electrical product such as a liquid crystal display device, an organic EL, electronic paper, a solar battery, and the like. It is to be noted that the present invention is also directed to a product or a part such as a liquid crystal display device, an organic EL, electronic paper, a solar battery, and the like including the electrode substrate of the present invention as described above.

Further, such a product or a part includes an electrode substrate including the electrode substrate of the present invention in a portion thereof.

### [Examples]

Hereinafter, the present invention will be described in more detail with reference to examples. It is to be noted that the present invention is not limited thereto.

### <Example 1>

A film-like PET with a thickness of 100 µm (product name: Luminar, manufactured by Toray Industries, Inc.) was used as transparent base material 101, and a dry film with a thickness of 10 µm (product name: RY3310, manufactured by Hitachi Chemical Co., Ltd.) was laminated thereon. Then, laminated dry film 104 was exposed and developed such that the first conductive layer would form a desired fine wiring pattern (Fig. 2).

Subsequently, transparent base material 101 having a pattern formed by dry film 104 thereon was introduced into a sputtering apparatus, and Ar gas was used to bombard cations to transparent base material 101 with an ion gun. Continuously, an Ni/Cr alloy (with a mass ratio of Ni : Cr = 80 : 20) was sputtered as a first conductive material, and continuously, Cu was sputtered as a first conductive material on the Ni/Cr alloy, thereby forming the first conductive layer 102 (Fig. 3; note, however, that the first conductive layer is shown as one layer). As a result of observing the cross section of the first conductive layer using an FIB (focused ion beam) apparatus, it was found that a layer of the Ni/Cr alloy had a thickness of 0.01 µm and a layer of Cu had a thickness of 0.3 µm.

Next, transparent base material 101 having the first conductive layer 102 formed thereon was introduced into a resist removing apparatus, and sprayed with an aqueous solution of sodium hydroxide. Then, a portion of dry film 104 not forming the pattern was removed with the first conductive layer attached thereto, and thereby the first conductive layer in the form of the pattern was formed (Fig. 4). On this occasion, the surface of transparent base material 101 was observed using an optical microscope, and it was able to be confirmed that the first conductive layer 102 formed a fine wiring pattern (wiring circuit) with a width of 10 µm on transparent base material 101.

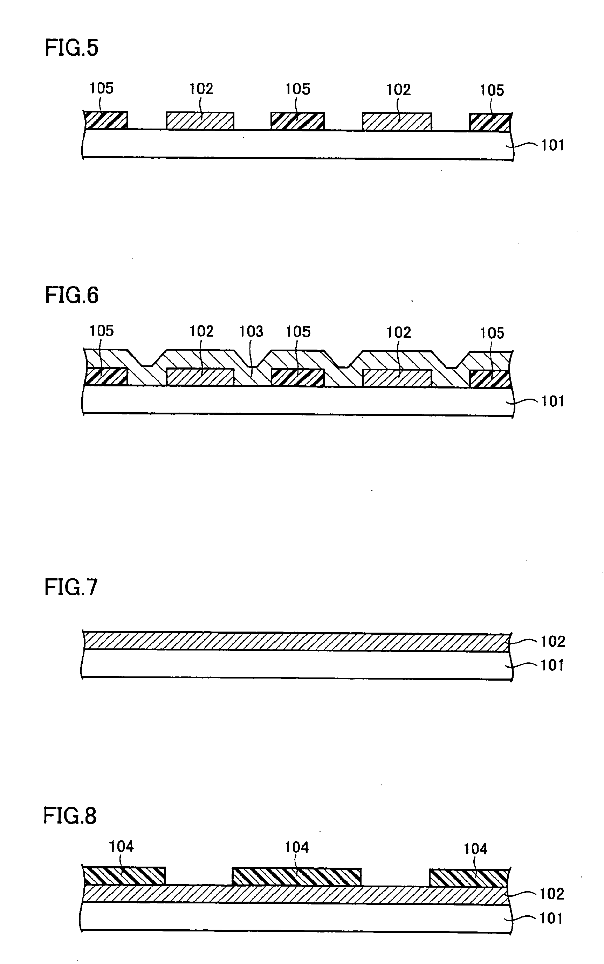

Subsequently, a dry film 105 identical to the one described above was laminated on transparent base material 101 having the pattern of the first conductive layer 102 formed thereon as described above, and dry film 105 was exposed and developed such that the second conductive layer 103 would be formed to cover the first conductive layer 102 (Fig. 5).

Next, transparent base material 101 having dry film 105 laminated thereon was introduced into the sputtering apparatus, and Ar gas was used to bombard cations to transparent base material 101 with the ion gun. Continuously, as a second conductive material, ITO (an oxide of Sn and In; with a mass ratio of Sn : In = 10 : 90) was sputtered with a small amount of oxygen being introduced thereinto, thereby forming the second conductive layer 103 made of ITO (with a mass ratio of Sn : In : O = 7.3 : 73.2 : 19.5) as the second conductive material on the first conductive layer 102 (Fig. 6). As a result of observing the cross section of the second conductive layer 103 using the FIB apparatus, it was found that the second conductive layer 103 had a thickness of 0.03 µm.

Subsequently, transparent base material 101 having the second conductive layer 103 formed thereon as described above was introduced into the resist removing apparatus, and sprayed with an aqueous solution of sodium hydroxide. Then, dry film 105 was removed with the second conductive layer 103 attached thereto, and thereby electrode substrate 100 of the present invention including the first conductive layer 102 and the second conductive layer 103 formed on transparent base material 101 was obtained (Fig. 1). The surface of electrode substrate 100 was observed using the optical microscope, and it was able to be confirmed that the second conductive layer 103 with a width of 250 µm was formed to cover the first conductive layer 102 formed as the fine wiring pattern (wiring circuit) on transparent base material 101. The wiring pattern (wiring circuit) was designed such that the adjacent second conductive layers had an interval of 20 µm.

### <Example 2>

Transparent base material 101 identical to that of example 1 was prepared and introduced into a sputtering apparatus, and Ar gas was used to bombard cations to transparent base material 101 with the ion gun. Continuously, an Ni/Cr alloy (with a mass ratio of Ni : Cr = 80 : 20) was sputtered as a first conductive material on the entire one surface of transparent base material 101, and continuously, Cu was sputtered as a first conductive material on the Ni/Cr alloy, thereby forming the first conductive layer 102 on the entire one surface of transparent base material 101 (Fig. 7; note, however, that the first conductive layer is shown as one layer). As a result of observing the cross section of the first conductive layer 102 using an FIB apparatus, it was found that a layer of the Ni/Cr alloy had a thickness of 0.01 µm and a layer of Cu had a thickness of 0.3 µm.

Next, dry film 104 identical to that used in example 1 was laminated on the first conductive layer 102 formed as described above. Then, laminated dry film 104 was exposed and developed such that the first conductive layer 102 would form a desired fine wiring pattern (Fig. 8).

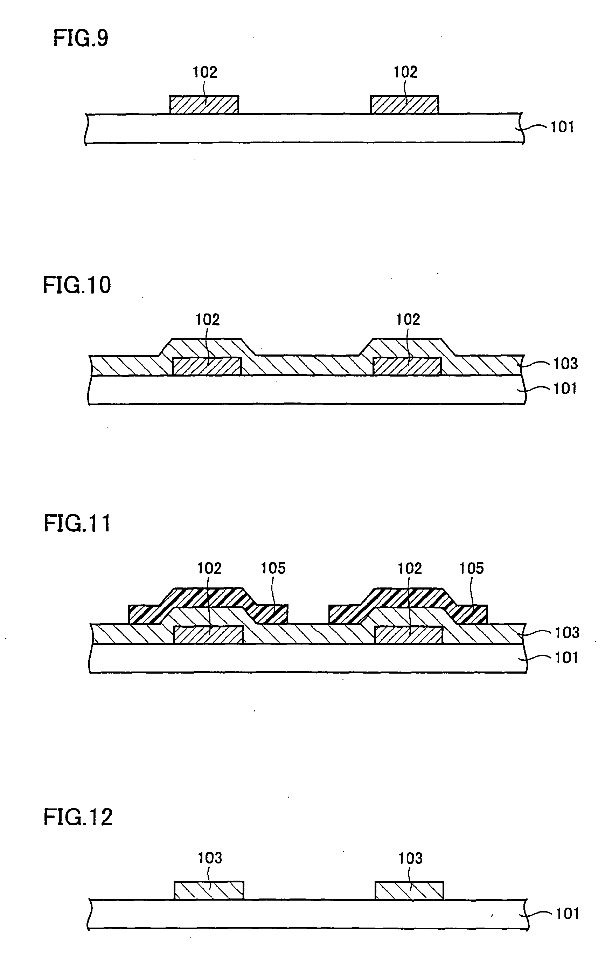

Subsequently, this work-in-process item was introduced into an etching apparatus to etch the first conductive layer 102 and remove dry film 104, and thereby the first conductive layer 102 in the form of the pattern was formed on transparent base material 101 (Fig. 9). On this occasion, the surface of transparent base material 101 was observed using the optical microscope, and it was able to be confirmed that the first conductive layer 102 formed a fine wiring pattern (wiring circuit) with a width of 10 µm on transparent base material 101.

Subsequently, transparent base material 101 having the pattern of the first conductive layer 102 formed thereon was introduced into the sputtering apparatus, and Ar gas was used to bombard cations to the surface thereof with the ion gun. Continuously, as a second conductive material, ITO (an oxide of Sn and In; with a mass ratio of Sn : In = 10 : 90) was sputtered onto the entire surface, with a small amount of oxygen being introduced thereinto, thereby forming the second conductive layer 103 made of ITO (with a mass ratio of Sn : In : O = 7.3 : 73.2 : 19.5) as the second conductive material on the entire surface of transparent base material 101 on which the first conductive layer 102 was formed in the form of the pattern (Fig. 10). As a result of observing the cross section of the second conductive layer 103 using the FIB apparatus, it was found that the second conductive layer 103 had a thickness of 0.03 µm.

Next, dry film 105 identical to the one described above was laminated on the second conductive layer 103 formed as described above, and laminated dry film 105 was exposed and developed such that the second conductive layer 103 would cover the first conductive layer 102 and form a desired fine wiring pattern (Fig. 11).

Subsequently, this work-in-process item was introduced into the etching apparatus to etch an unnecessary portion of the second conductive layer 103 and remove dry film 105, and thereby electrode substrate 100 of the present invention including the first conductive layer 102 and the second conductive layer 103 formed on transparent base material 101 was obtained (Fig. 1). The surface of electrode substrate 100 was observed using the optical microscope, and it was able to be confirmed that the second conductive layer 103 with a width of 250 µm was formed to cover the first conductive layer 102 formed as the fine wiring pattern (wiring circuit) on transparent base material 101. The wiring pattern (wiring circuit) was designed such that the adjacent second conductive layers had an interval of 20 µm.

### <Example 3>

The first conductive layer 102 in the form of a pattern was formed on transparent base material 101 in a manner identical to that of example 1 (Figs. 2 to 4).

Continuously, the second conductive layer 103 was formed to cover the first conductive layer 102 formed as a fine wiring pattern (wiring circuit) on transparent base material 101 in a manner identical to that of example 2 (Figs. 9 to 11), and thereby electrode substrate 100 of the present invention was obtained (Fig. 1).

### <Example 4>

The first conductive layer 102 in the form of a pattern was formed on transparent base material 101 in a manner identical to that of example 2 (Figs. 7 to 9).

Continuously, the second conductive layer 103 was formed to cover the first conductive layer 102 formed as a fine wiring pattern (wiring circuit) on transparent base material 101 in a manner identical to that of example 1 (Figs. 4 to 6), and thereby electrode substrate 100 of the present invention was obtained (Fig. 1).

### <Example 5>

The electrode substrate of the present invention was obtained in a manner identical to that of example 1 except that the second conductive layer had a width of 18 µm.

### <Example 6>

The electrode substrate of the present invention was obtained in a manner identical to that of example 1 except that the second conductive layer had a width of 100 µm.

### <Example 7>

The electrode substrate of the present invention was obtained in a manner identical to that of example 1 except that the second conductive layer had a width of 500 µm.

### <Example 8>

The electrode substrate of the present invention was obtained in a manner identical to that of example 1 except that the second conductive layer had a width of 1000 µm.

### <Example 9>

The electrode substrate of the present invention was obtained in a manner identical to that of example 1 except that the second conductive layer had a width of 2500 µm.

### < Example 10>

The electrode substrate of the present invention was obtained in a manner identical to that of example 1 except that an Ni layer made ofNi (thickness: 0.3 µm) was formed instead of the Cu layer constituting the first conductive layer.

### <Example 11>

The electrode substrate of the present invention was obtained in a manner identical to that of example 1 except that the second conductive layer (thickness: 0.03 µm, width: 250 µm) was made of SnO instead of ITO.

### <Comparative Example 1>

Transparent base material 101 identical to that of example 1 was prepared and introduced into a sputtering apparatus, and Ar gas was used to bombard cations to transparent base material 101 with the ion gun, in a manner identical to that of example 1. Continuously, as the second conductive material identical to that of example 1, ITO was sputtered with a small amount of oxygen being introduced thereinto, thereby forming the second conductive layer 103 on the entire one surface of transparent base material 101.

Next, dry film 104 identical to the one used in example 1 was laminated on the second conductive layer 103 formed as described above, and laminated dry film 104 was exposed and developed such that the second conductive layer 103 would form a desired fine wiring pattern as in example 1.

Subsequently, this work-in-process item was introduced into an etching apparatus to etch the second conductive layer 103 and remove dry film 104, and thereby an electrode substrate of a comparative example in which only the second conductive layer 103 in the form of the pattern was formed on transparent base material 101 was obtained (Fig. 12).

As a result of observing the cross section of the second conductive layer 103 of the electrode substrate using an FIB apparatus, it was found that the second conductive layer 103 had a thickness of 0.05 µm. Further, as a result of observing the surface of transparent base material 101 using the optical microscope, it was able to be confirmed that the second conductive layer 103 formed a fine wiring pattern (wiring circuit) with a width of 250 µm similar to that of example 1.

### <Comparative Example 2>

An electrode substrate of a comparative example was obtained in a manner identical to that of comparative example 1 except that the second conductive layer had a thickness of 0.2 µm.

### <Comparative Example 3>

An electrode substrate of a comparative example was obtained in a manner identical to that of example 1 except that the second conductive layer was not formed and only the first conductive layer was formed.

### <Comparative Example 4>

An electrode substrate of a comparative example was obtained in a manner identical to that of example 1 except that the second conductive layer had a width of 13 µm.

### <Comparative Example 5>

An electrode substrate of a comparative example was obtained in a manner identical to that of example 1 except that the second conductive layer had a width of 3500 µm.

### <Evaluation>

Using the electrode substrates obtained in examples 1 to 11 and comparative examples 1 to 5 described above, conductivity, transparency, and resistance to migration were evaluated as described below. Table 1 shows results of the evaluation.

### (Evaluation of Conductivity - Measurement of Electrical Resistance)

Electrical resistance values at five different points in a wiring pattern (wiring circuit) portion, each point having a measurement area of a 20 mm diameter circle, were measured by the four terminal method using an electrical resistance measurement apparatus (manufactured by Mitsubishi Chemical Corporation, product number: MCP-T610) (note that these five measurement points were located at common positions in the respective examples/comparative examples). Table 1 shows average values thereof. Since the wiring pattern in each example/comparative example was designed such that the interval between the second conductive layers was 20 µm as described above, the first conductive layer and the second conductive layer were present at each measurement point in accordance with the ratio between the width of the first conductive layer and the width of the second conductive layer. The lower the value, the more excellent the conductivity.

### (Evaluation of Conductivity - Measurement of Electrical Conductivity across Wiring Pattern)

Electrical conductivity across the wiring pattern (wiring circuit) portion was measured using an LCR meter (manufactured by Custom, product number: ELC-100). Table 1 shows results thereof. Since the distance across the wiring pattern in each example/comparative example was designed to be equal, the lower the value, the more excellent the conductivity.

### (Evaluation of Transparency)

Light transmissivity in the wiring pattern (wiring circuit) portion was measured at the same measurement points (five points) as those for the electrical resistance measurement described above having the same measurement area, using a turbidimeter (manufactured by Nippon Denshoku Industries Co., Ltd., product number: NDH-2000). Table 1 shows average values thereof. Since the wiring pattern in each example/comparative example was designed such that the interval between the second conductive layers was 20 µm as described above, the first conductive layer and the second conductive layer were present at each measurement point in accordance with the ratio between the width of the first conductive layer and the width of the second conductive layer. The higher the value, the more excellent the transparency.

### (Evaluation of Resistance to Migration)

A voltage of 60 mV was continuously applied to the wiring pattern (wiring circuit) portion for 48 hours with the electrode substrate maintained at a temperature of 85°C and a humidity of 85%, using a migration test apparatus (manufactured by ESPEC Corp., product number: AMI-025-PL-5). Thereafter, the wiring pattern portion was observed with an optical microscope to confirm presence or absence of migration. Table 1 shows results thereof, in which the word "present" indicates the presence of migration in the first conductive layer, and the word "absent" indicates the absence of migration in the first conductive layer.

**Table 1**

| | Evaluation of Conductivity | | Evaluation of Transparency [%] | Evaluation of Resistance to Migration |
|---|---|---|---|---|
| | Electrical Resistance [Ω] | Electrical Conductivity across Wiring Pattern [kΩ] | | |
| Example 1 | 3.5 | 0.3 | 87 | absent |
| Example 2 | 3.5 | 0.3 | 87 | absent |
| Example 3 | 3.5 | 0.3 | 87 | absent |
| Example 4 | 3.5 | 0.3 | 87 | absent |
| Example 5 | 0.5 | 0.3 | 55 | absent |
| Example 6 | 1.6 | 0.3 | 69 | absent |
| Example 7 | 7.0 | 0.3 | 89 | absent |
| Example 8 | 14.0 | 0.3 | 90 | absent |
| Example 9 | 29.0 | 0.3 | 91 | absent |
| Example 10 | 11.0 | 0.9 | 87 | absent |
| Example 11 | 3.3 | 0.3 | 87 | absent |
| Comparative | 33.0 | 60 | 85 | absent |
| Example 1 | | | | |
| Comparative | 270.0 | 400 | 87 | absent |
| Example 2 | | | | |
| Comparative | 3.6 | 0.3 | 88 | present |
| Example 3 | | | | |
| Comparative | 0.45 | 0.3 | 45 | absent |
| Example 4 | | | | |
| Comparative | 47.5 | 0.3 | 91 | absent |
| Example 5 | | | | |

As can be seen from table 1, the electrode substrates having the structure of the present invention highly achieved both conductivity and transparency, when compared with the electrode substrates of the comparative examples.

Although the present invention has been described and illustrated in detail, it is to be clearly understood that the same is by way of illustration and example only and is not to be taken by way of limitation, the scope of the present invention being defined only by the appended claims.

## Claims

1. An electrode substrate (100) comprising a first conductive layer (102) made of a first conductive material and a second conductive layer (103) made of a second conductive material formed on a transparent base material (101), wherein
said first conductive layer (102) is formed on said transparent base material (101),
said second conductive layer (103) is formed on said transparent base material (101) to cover said first conductive layer (102),
both said first conductive layer (102) and said second conductive layer (103) form a fine wiring pattern,
said second conductive layer (103) has a width not less than 1.5 times and not more than 300 times that of said first conductive layer (102), and
said second conductive material has a light transmissivity higher than that of said first conductive material, and a conductivity lower than that of said first conductive material.

2. The electrode substrate (100) according to claim 1, wherein
said first conductive material is at least one type of metal selected from the group consisting ofNi, Cu, Ag, Al, and Cr, or an alloy containing the metal, and
said second conductive material is an oxide of at least one type of metal selected from the group consisting of Ru, Re, Pb, Cr, Sn, In, and Zn.

3. The electrode substrate (100) according to claim 1, wherein
said first conductive layer (102) has a thickness of not less than 0.001 µm and not more than 5 µm, and a width of not less than 1 µm and not more than 3 mm, and
said second conductive layer (103) has a thickness of not less than 0.001 µm and not more than 1 µm, and a width of not less than 1.5 µm.

4. A part or a product comprising the electrode substrate (100) according to claim 1.
